(19) Europäisches Patentamt
European Patent Office
Office européen des brevets

(11) **EP 1 602 919 B1**

(12) **EUROPÄISCHE PATENTSCHRIFT**

(45) Veröffentlichungstag und Bekanntmachung des Hinweises auf die Patenterteilung:
**13.02.2008 Patentblatt 2008/07**

(51) Int Cl.:
*C23C 14/54* *(2006.01)*  *G01N 21/55* *(2006.01)*
*G01N 21/59* *(2006.01)*  *G01N 21/84* *(2006.01)*
*G01N 21/958* *(2006.01)*

(21) Anmeldenummer: **04012900.9**

(22) Anmeldetag: **01.06.2004**

(54) **Messvorrichtung für die Messung des Transmissionsgrads einer Beschichtung**

Measuring device for the survey of the transmittance of a coating

Appareil de mesure pour l'étude de la transmittance d'un enduit

(84) Benannte Vertragsstaaten:
**AT BE BG CH CY CZ DE DK EE ES FI FR GB GR HU IE IT LI LU MC NL PL PT RO SE SI SK TR**

(43) Veröffentlichungstag der Anmeldung:
**07.12.2005 Patentblatt 2005/49**

(73) Patentinhaber: **Applied Materials GmbH & Co. KG**
**63755 Alzenau (DE)**

(72) Erfinder: **Schröder, Jürgen**
**63538 Grosskrotzenburg (DE)**

(74) Vertreter: **Schickedanz, Willi**
**Langener Strasse 68**
**63073 Offenbach (DE)**

(56) Entgegenhaltungen:
| | |
|---|---|
| **EP-A- 0 324 351** | **DE-A- 3 806 382** |
| **DE-A- 3 925 536** | **DE-A- 4 127 701** |
| **DE-A- 4 201 274** | **DE-B- 1 195 135** |
| **DE-C- 10 141 897** | **GB-A- 2 029 017** |
| **US-A- 4 765 273** | **US-A1- 2002 186 381** |
| **US-B1- 6 194 701** | **US-B1- 6 359 686** |

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Messvorrichtung nach dem Oberbegriff des Patentanspruchs 1.

Die Beschichtung von Substraten, beispielsweise von Glasscheiben mittels Sputtern, soll möglichst gleichmäßig erfolgen. Nur dann, wenn die Beschichtungen über das ganze Substrat die gleiche Dicke haben, ist gewährleistet, dass auch die optischen Eigenschaften wie Transmission, Reflexion und elektrischer Widerstand der Beschichtungen überall gleich sind.

Die Messung dieser optischen Eigenschaften erfolgt üblicherweise anhand von beschichteten Substrat-Proben. Dabei werden Substrat-Proben entnommen und im Labor untersucht, was mit einem erheblichen Zeitaufwand verbunden ist. Dies gilt insbesondere für die Charakterisierung von Großflächenbeschichtungen, weil in diesem Fall eine Vielzahl von Proben entnommen und untersucht werden muss. Für die flächendeckende Erfassung der spektralen Reflexion, der spektralen Transmission und des Flächenwiderstands sind bei guter Ortsauflösung etwa 80 Stunden Arbeitszeit erforderlich.

Es sind bereits ein Verfahren und eine Vorrichtung zum Prüfen von laufenden transparenten Bahnen bekannt (DE 38 06 382 A1). Hierbei wird durch Abtasten der zu prüfenden transparenten Bahn mit einem Lichtstrahl das reflektierte und/oder transmittierte Licht oberhalb und unterhalb der transparenten Bahn erfasst.

Weiterhin ist ein System zum Überprüfen von Oberflächendefekten und Glasdefekten von Glassubstraten bekannt (US 6 359 686 B1). Das Glas wird hierbei während des Prüfvorgangs von einem schräg gestellten Lufttisch gestützt, um in der Ebene eine Stabilität zu erzeugen und um Vibrationen zu verringern. Das System weist einen Abtastmechanismus auf, der aus Teilen besteht, die sich auf verschiedenen Seiten des Lufttischs befinden, der Schlitze aufweist. Das Substrat wird parallel zum Lufttisch bewegt.

Aufgabe der Erfindung ist es, neben einer Messvorrichtung für die Messung des Transmissionsgrads einer Beschichtung, die sich auf einem in x-Richtung bewegbaren plattenförmigen Substrat befindet, noch eine Messvorrichtung für die Messung anderer Eigenschafen der Beschichtung vorzusehen.

Diese Aufgabe wird gemäß den Merkmalen des Patentanspruchs 1 gelöst

Der mit der Erfindung erzielte Vorteil besteht insbesondere darin, dass die Transmission eines beschichteten plattenförmigen Substrats an allen Oberflächenpunkten automatisch gemessen werden kann. Darüber hinaus ist es bei einer Ausgestaltung der Erfindung möglich, auch noch die spektrale Reflexion und den Flächenwiderstand der Beschichtung automatisch zu messen. Als Substrat wird in der Regel Flachglas mit einer Dicke von 0,5 mm bis 6 mm verwendet, wobei die Größe der Glasscheibe etwa 2,2 m x 2,4 m betragen kann. Die beliebig wählbaren Messorte auf der Glasscheibe werden mit einer Genauigkeit von < 5 mm absolut und < 1 mm relativ angefahren. Die Messgeschwindigkeit beträgt mehr als 1000 Messungen pro Stunde bei simultaner Messung der Transmission $T(\lambda)$, der Reflexion $R(\lambda)$ und des Flächenwiderstands R. Werden nur $T(\lambda)$ und $R(\lambda)$ gemessen, sind mehr als 2000 Messungen pro Stunde möglich. Die Messung des Flächenwiderstands erfolgt nach der Vierpunkt-Methode, wobei der Messbereich zwischen 10 m$\Omega$ und 1000 $\Omega$ liegt. Aus den Messungen von $T(\lambda)$ und $R(\lambda)$ kann die Dicke der Beschichtung auf dem Glas berechnet werden.

Ein Ausführungsbeispiel der Erfindung ist in den Zeichnungen dargestellt und wird im Folgenden näher beschrieben. Es zeigen:

Fig. 1      eine Stützplatte mit Glasscheibe und Messgeräten;

Fig. 2      eine vergrößerte Teilansicht aus Fig. 1;

Fig. 3      eine Draufsicht auf die Vorrichtung gemäß Fig. 2;

Fig. 4      das Ende eines Widerstandsmesskopfs;

Fig. 5      eine Anordnung zur Vierpunkt-Widerstandsmessung.

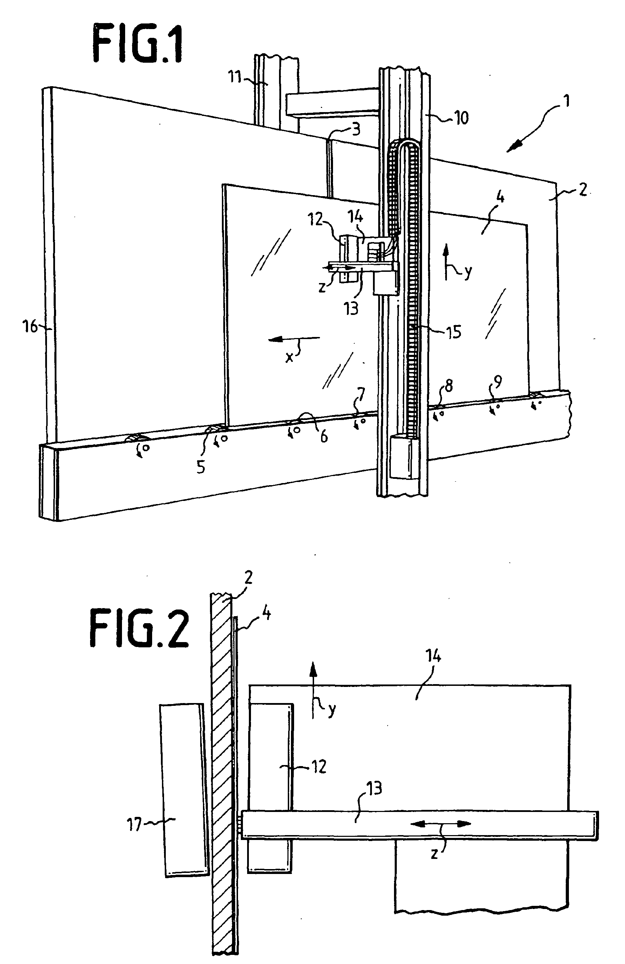

In der Fig. 1 ist eine Vorrichtung 1 zum Messen von Parametern bzw. Eigenschaften einer Beschichtung eines Substrats dargestellt. Diese Vorrichtung 1 weist eine Stützplatte 2 auf, die in der Mitte mit einem vertikalen Schlitz 3 versehen ist. Vor dieser Stützplatte 2 befindet sich eine beschichtete Glasscheibe 4, die unter einem Winkel zwischen 4° und 10° zur Vertikalen auf Walzen 5 bis 9 ruht. Die Glasscheibe 4 weist hierbei auf ihrer von der Stützplatte 2 weg weisenden Seite eine Beschichtung auf, die beispielsweise mittels eines Sputterprozesses aufgebracht wurde. Durch Düsen, die in Fig. 1 nicht dargestellt sind, strömt in den Raum zwischen Glasscheibe 4 und Stützplatte 2 Luft, sodass die Glasscheibe auf einem Luftpolster ruht. Nähere Einzelheiten hierzu sind in der PCT-Anmeldung PCT/EP2004/002333 beschrieben.

Die Walzen 5 bis 9 werden synchron durch einen in Fig. 1 nicht dargestellten Motor im Uhr- oder Gegenuhrzeigersinn gedreht. Durch eine solche Drehung wird die Glasscheibe 4 relativ zur ortsfesten Stützplatte 2 entweder nach rechts oder nach links verschoben.

Ebenfalls ortsfest angeordnet sind zwei Säulen 10, 11, von denen eine Säule 10 vor der Stützplatte 2 und eine Säule 11 hinter der Stützplatte 2 vorgesehen ist. Diese Säulen 10, 11 tragen Messgeräte, die vertikal, d. h. in $\gamma$-Richtung bewegbar sind. Bei dem einen Messgerät 12 handelt es sich um ein Reflexionsmessgerät, während es sich bei dem anderen Messgerät 13 um einen Widerstandsmesskopf handelt. Beide Messgeräte 12, 13 sind an einem Schlitten 14 befestigt. Die Bewegung der Messgeräte 12, 13 in $\gamma$-Richtung erfolgt über

einen in die Säule 10 integrierten, nicht dargestellten Riemenantrieb, der den Schlitten 14 bewegt. Die Versorgungsleitungen und Messkabel für die Messgeräte 12, 13 werden in der Schleppkette 15 geführt. Ähnlich wie die Säule 10 trägt auch die Säule 11 ein Messgerät, allerdings nur ein lichtempfangendes Messgerät, das in Fig. 1, nicht zu erkennen ist, aber wie das optische Messgerät 12 unmittelbar in der Nähe des Spalts 3 angeordnet ist.

Der Transport der Glasscheibe 4 erfolgt in drei Phasen: Zunächst wird das erwähnte Luftkissen zwischen Stützplatte 2 und Glasscheibe 4 erzeugt. Hierauf werden die Walzen 5 bis 9 gedreht, die aufgrund der zwischen den Walzen 5 bis 9 und der Unterkante der Glasscheibe 4 bestehenden Reibungskraft die Glasscheibe 4 in x-Richtung bewegen. Nach Erreichen einer vorgegebenen Messposition wird die Luft abgeschaltet, sodass sich das Luftpolster wieder abbaut.

Der Widerstandsmesskopf 13 liegt während des Messvorgangs auf der Beschichtung auf. Um den nächsten Messvorgang durchzuführen, muss er von der Beschichtung entfernt werden. Der Widerstandsmesskopf 13 führt somit dann, wenn er nacheinander mehrere Messungen vornimmt, eine hin und her gehende Bewegung in z-Richtung durch.

In der Fig. 2 ist eine Ansicht auf die Kante 16 der Stützplatte 2 gezeigt. Man erkennt hierbei, dass sich vor der Glasscheibe 4 das Reflexionsmessgerät 12 befindet. Hinter der Glasscheibe 4 befindet sich ein Transmissionsmessgerät 17. Das Transmissionsmessgerät erfasst die Intensität der im Reflexionsmessgerät enthaltenen Beleuchtungsquelle, vermindert um die Reflexions- und Absorptionsverluste der Schicht bzw. der Glasscheibe 4. Somit erfasst es die Intensität des durch die Probe hindurchgehenden Lichts. Das Reflexionsmessgerät 12 und das Transmissionsmessgerät 17 bewegen sich synchron in y-Richtung. Die Lichtquelle im Reflexionsmessgerät 12 beleuchtet somit sowohl die Beschichtung der Glasscheibe 4 als auch das Transmissionsmessgerät 17. Dieses Transmissionsgerät 17 ist relativ zur Stützplatte 2 leicht geneigt, damit die von seinem Sensor reflektierten Strahlen nicht über die Probe in dieses zurückgeworfen werden. Die Stützplatte 2 und die Glasscheibe 4 sind etwas nach links geneigt, damit die Glasscheibe 4 nicht nach rechts herunterfällt.

Der Widerstandsmesskopf 13 ist an dem gleichen Schlitten 14 wie das Reflexionsmessgerät 12 befestigt. Beide Geräte haben einen bestimmten Abstand in x-Richtung voneinander, werden aber synchron in γ-Richtung bewegt. Bei dem Reflexionsmessgerät 12 kann es sich beispielsweise um das Gerät "Zeiss Corona D vis" handeln.

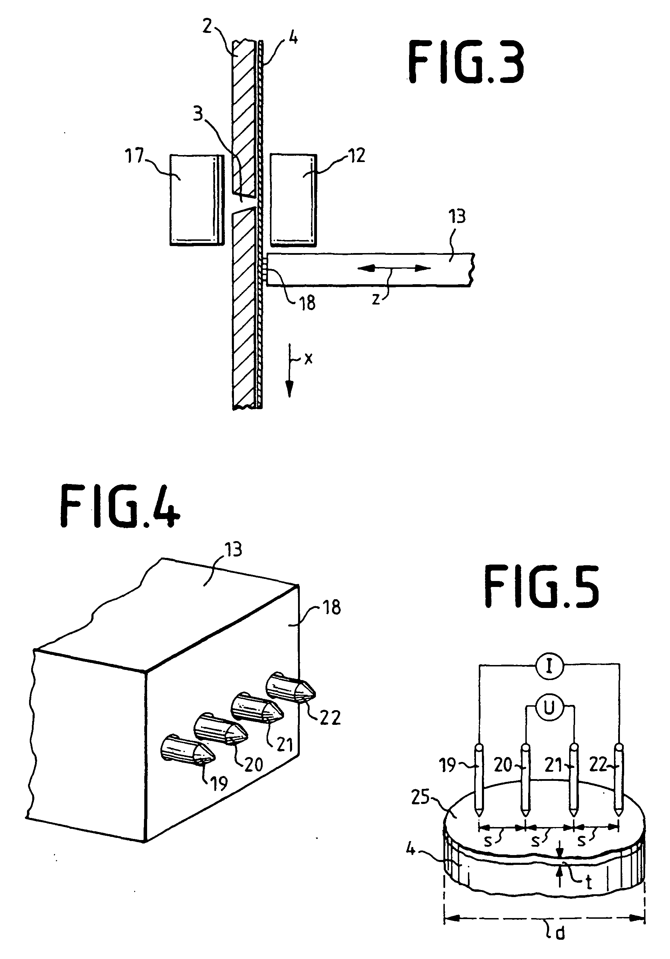

Die Fig. 3 zeigt eine Ansicht von oben auf die wesentlichen Bauelemente der Fig. 2. Man erkennt hierbei, dass sich das Reflexionsmessgerät 12 und das Transmissionsmessgerät 17 auf der Höhe des Spalts 3 gegenüberliegen. Hierdurch können die Lichtstrahlen ohne Behinderung durch die Stützplatte 2 vom Reflexionsmessgerät 12 zum Transmissionsgerät 17 gelangen. Die Weißlichtquelle, die sich in dem Reflexionsgerät 12 befindet, liefert sowohl das Licht für die Reflexionsmessung als auch für die Transmissionsmessung. Bei dem Transmissionsmessgerät 17 kann es sich um das Gerät "Zeiss Corona TV vis" handeln.

Die Fig. 4 zeigt das Ende 18 des Widerstandsmesskopfs 13. Man erkennt hierbei vier Stifte 19, 20, 21, 22, die federnd gelagert sind. Mit diesen vier Stiften 19 bis 22 kann eine so genannte Vierpunkt-Messung an der Beschichtung der Glasscheibe durchgeführt werden. Die Stifte 19 bis 22 sind federnd gelagert und weisen einen Druckpunkt auf, wodurch alle vier Stifte 19 bis 22 mit jeweils der gleichen Kraft auf die Beschichtung drücken. Auch der Widerstandsmesskopf 13 selbst ist federnd gelagert, wobei die einstellbare Federkraft des Widerstandsmesskopfs etwas größer als die Summe der vier Federkräfte der Stifte 19 bis 22 ist.

Ein Verbiegen der Glasscheibe 4 durch den von den Stiften 19 bis 22 ausgeübten Druck wird durch die Stützplatte 2 verhindert, auf welcher die Glasscheibe 4 aufliegt.

Der Abstand zwischen der optischen Messachse der optischen Messgeräte und dem Ort der Widerstandsmessung ist eine vorgegebene Größe, sodass dann, wenn der Ort der optischen Messachse bekannt ist, auch der Ort der Widerstandsmessung bekannt ist und umgekehrt.

In der Fig. 5 ist das - an sich bekannte - Vierpunkt-Messverfahren noch einmal im Prinzip dargestellt. Man erkennt hierbei einen Ausschnitt aus einer Glasscheibe 4 mit einer Beschichtung 25. Mit Hilfe der vier Stifte, die unter Federspannung auf die Beschichtung 25 aufgesetzt werden, soll der Widerstand der Beschichtung 25 gemessen werden. Für Ausschnitte, deren Breite d viel größer als der Abstand s zwischen den Stiften 19 bis 22 ist und deren Dicke t viel kleiner als der Abstand s ist, errechnet sich der Flächenwiderstand nach der Formel

$$R = \frac{\pi}{\ln(2)}\left(\frac{U}{I}\right) = 4.5324\left(\frac{U}{I}\right)$$

Ein üblicher Wert für s ist beispielsweise s = 1,0 mm. Die vorstehende Gleichung gilt, wenn die Bedingungen d > 10 s und 10 t < s erfüllt sind, d. h. die Gleichung ist anwendbar bei Schichtdicken von t ≤ 100 μm. Dieser Gültigkeitsbereich ist völlig ausreichend für Messungen an dünnen Schichten im Nanometerbereich.

Indem die Glasscheibe 4 in x-Richtung und die Messgeräte 12, 13, 17 in γ-Richtung bewegt werden, ist es möglich, für alle Punkte auf der beschichteten Glasscheibe 4 die Transmission, Reflexion und den Widerstand zu ermitteln. Die Transmission und die Reflexion liegen dann als Messkurven T = f(λ) bzw. R = f(λ) vor, die datenmäßig nur schwer zu bearbeiten sind.

Eine einfache Bearbeitung wird jedoch dadurch möglich, dass jeder Messkurve ein Farbort in einer Farbtafel zugeordnet werden kann, beispielsweise in einer Normfarbtafel CIE 1931, bei welcher die Normfarbwertanteile in einem rechtwinkligen Koordinatensystem dargestellt sind. Die gemessenen Reflexions- und Transmissionskurven müssen dann lediglich mit den Spektralkurven der verwendeten Lichtquelle und der Hellempfindlichkeitskurve des menschlichen Auges, der so genannten $V_\lambda$-Kurve, multipliziert werden. Eine andere Möglichkeit der Bearbeitung der T($\lambda$)- und R($\lambda$)-Spektralkurven besteht darin, die Wellenlänge lokaler Maxima und Minima zu bestimmen. Diese Wellenlänge ist über den Brechwert der Beschichtung mit der Schichtdicke verknüpft, d. h. eine Verschiebung der Wellenlänge lokaler Maxima und Minima ist proportional einer Schichtdickenänderung.

Indem die optischen und die elektrischen Messwerte über die ganze Oberfläche der Glasscheibe 4 in sehr kurzer Zeit erfasst werden, ist es möglich, die Gleichmäßigkeit der Beschichtung 25 zu ermitteln. Diese Gleichmäßigkeit kann optisch dargestellt werden, beispielsweise durch Darstellung von Farbfeldern in einem Rahmen, welcher der Größe der Glasscheibe 4 entspricht.

Aufgrund der ermittelten Gleichmäßigkeitsverteilung der Beschichtung kann der Beschichtungsprozess selbst geregelt werden. Wird beispielsweise festgestellt, dass die rechte obere Ecke der Glasscheibe zu dünn beschichtet ist, kann durch geeignete Maßnahmen in einem Sputterprozess, z. B. Spannungserhöhung, bewirkt werden, dass diese Ecke beim nächsten Durchlauf stärker beschichtet wird.

**Patentansprüche**

1. Messvorrichtung (1) zum Messen wenigstens einer optischen Eigenschaft der Beschichtung eines plattenförmigen Substrats (4), mit

a) einer Vorrichtung (5 - 9) zum Transportieren des Substrats (4) in einer ersten Richtung,
b) wenigstens einer Messvorrichtung (12, 17),
c) einer Vorrichtung (14, 15) zum Transportieren der Messvorrichtung (12, 17) in eine zweite Richtung, die zur ersten Richtung senkrecht verläuft,
d) einer ortsfesten Auflage (2) für das Substrat (4), die in der zweiten Richtung einen durchgehenden Spalt (3) aufweist,
e) wenigstens einer Messvorrichtung (12, 17), die auf der einen Seite des Substrats (4) einen Lichtsender (12) und auf der anderen Seite des Substrats (4) einen Lichtempfänger (17) aufweist, sodass das Licht des Lichtsenders (12) durch den Spalt (3) auf den Lichtempfänger (17) trifft,

**dadurch gekennzeichnet,**
f) **dass** die Beschichtung auf einer Seite des Substrats (4) vorgesehen ist,
g) **dass** sich auf derjenigen Seite des Substrats (4), auf der sich die Beschichtung befindet, ein Widerstandsmessgerät (13) befindet und
h) **dass** die Vorrichtung (14, 15) zum Transportieren der Messvorrichtung (12, 17) auch zum synchronen Transportieren des Widerstandsmessgeräts (13) in die zweite Richtung dient.

2. Messvorrichtung nach Anspruch 1, **dadurch gekennzeichnet, dass** ein Datenspeicher vorgesehen ist, in dem die optischen Messwerte mit ihren zugehörigen Ortskoordinaten abgespeichert sind.

3. Messvorrichtung nach Anspruch 1, **dadurch gekennzeichnet, dass** der Lichtsender (12) einen Lichtempfänger für den Empfang des von der Beschichtung des Substrats (4) reflektierten Lichts enthält.

4. Messvorrichtung nach Anspruch 1, **dadurch gekennzeichnet, dass** das Widerstandsmessgerät (13) in einem vorgegebenen Abstand vom Lichtsender (12) angeordnet ist.

5. Messvorrichtung nach Anspruch 1, **dadurch gekennzeichnet, dass** das Widerstandsmessgerät (13) ein 4-Punkt-Widerstandsmessgerät und in einer dritten Richtung, die zur ersten und zweiten Richtung senkrecht verläuft, bewegbar ist.

6. Messvorrichtung nach Anspruch 1, **dadurch gekennzeichnet, dass** ein Datenspeicher vorgesehen ist, in dem die gemessenen Widerstandswerte mit ihren zugehörigen Ortskoordinaten abgespeichert sind.

7. Messvorrichtung nach Anspruch 1, **dadurch gekennzeichnet, dass** für den Transport des plattenförmigen Substrats (4) eine Transporteinrichtung (5 bis 9) vorgesehen ist, auf der eine Seitenkante des Substrats (4) ruht.

8. Messvorrichtung nach Anspruch 1, **dadurch gekennzeichnet, dass** der Lichtsender (12) in einem Gehäuse angeordnet ist, in dem sich auch ein Lichtempfänger befindet, sodass die Reflexion der Beschichtung messbar ist.

**Claims**

1. A measuring device (1) for measuring at least one optical characteristic of the coating of a plate-form substrate (4) with

a) a device (5 - 9) for transporting the substrate (4) in a first direction,

b) at least one measuring device (12, 17),

c) a device (14, 15) for transporting the measuring device (12, 17) in a second direction which runs perpendicularly to the first direction,

d) a stationary support (2) for the substrate (4) which has a continuous gap (3) in the second direction,

e) at least one measuring device (12, 17) which has on the one side of the substrate (4) a light transmitter (12) and on the other side of the substrate (4) has a light receiver (17), so that the light of the light transmitter (12) impinges through the gap (3) onto the light receiver (17), **characterized in that**

f) the coating is provided on one side of the substrate (4),

g) a resistance measuring instrument (13) is situated on the side of the substrate (4) on which the coating is situated and

h) the device (14, 15) for transporting the measuring device (12, 17) also serves for the synchronous transportation of the resistance measuring instrument (13) in the second direction.

2. Measuring device as claimed in claim 1, **characterized in that** a data store is provided, in which the measured optical values with their associated spatial co-ordinates are stored.

3. Measuring device as claimed in claim 1, **characterized in that** the light transmitter (12) includes a light receiver for the reception of the light reflected by the coating of the substrate (4).

4. Measuring device as claimed in claim 1, **characterized in that** a resistance measuring instrument (13) is disposed at a specified distance from the light transmitter (12).

5. Measuring device as claimed in claim 1, **characterized in that** the resistance measuring instrument (13) is a four-point resistance measuring instrument and can be moved in a third direction, which runs perpendicularly to the first and second direction.

6. Measuring device as claimed in claim 1, **characterized in that** a data store is provided, in which the measured resistance values with their associated spatial coordinates are stored.

7. Measuring device as claimed in claim 1, **characterized in that** for the transport of the plate-form substrate (4) a transporting device (5 to 9) is provided, on which rests a side edge of the substrate (4).

8. Measuring device as claimed in claim 1, **character-**

**ized in that** the light transmitter (12) is disposed in a housing, in which is also located a light receiver, such that the reflection of the coating can be measured.

## Revendications

1. Dispositif de mesure (1) pour mesurer au moins une propriété optique du revêtement d'un substrat (4) en forme de panneau, avec

a) un dispositif (5 à 9) pour transporter le substrat (4) dans une première direction,

b) au moins un dispositif de mesure (12, 17),

c) un dispositif (14, 15), pour transporter le dispositif de mesure (12, 17) dans une deuxième direction, s'écoulant à la perpendiculaire par rapport à la première direction,

d) un support stationnaire (2) pour le substrat (4), qui dans la deuxième direction comporte un interstice continu (3),

e) au moins un dispositif de mesure (12, 17), qui sur l'un des côtés du substrat (4) comporte un émetteur de lumière (12) et sur l'autre côté du substrat (4) comporte un récepteur de lumière (17), pour que la lumière de l'émetteur de lumière (12) soit incidente à travers l'interstice (3) sur le récepteur de lumière (17), **caractérisé en ce que**,

f) le revêtement est prévu sur un côté du substrat (4),

g) **en ce que** sur le côté du substrat (4) sur lequel se trouve le revêtement se trouve un dispositif de mesure de la résistance (13) et

h) **en ce que** le dispositif (14, 15) pour le transport du dispositif de mesure (12, 17) sert également au transport synchrone du dispositif de mesure de la résistance (13) dans la deuxième direction.

2. Dispositif de mesure selon la revendication 1, **caractérisé en ce que**, il est prévu une mémoire de données, dans laquelle sont mémorisées les valeurs de mesure optique, avec leurs coordonnées de lieu correspondantes.

3. Dispositif de mesure selon la revendication 1, **caractérisé en ce que**, l'émetteur de lumière (12) comprend un récepteur de lumière, pour réceptionner la lumière réfléchie par le revêtement du substrat (4).

4. Dispositif de mesure selon la revendication 1, **caractérisé en ce que,** le dispositif de mesure de la résistance (13) est disposé à une distance prédéfinie par rapport à l'émetteur de lumière (12).

5. Dispositif de mesure selon la revendication 1, **ca-**

**ractérisé en ce que**, le dispositif de mesure de la résistance (13) est un dispositif de mesure de la résistance à 4 points, et **en ce qu'**il est mobile dans une troisième direction, qui s'écoule à la perpendiculaire de la première et de la deuxième direction.

6. Dispositif de mesure selon la revendication 1, **caractérisé en ce que**, il est prévu une mémoire de données, dans laquelle sont mémorisées les valeurs de mesure de la résistance, avec leurs coordonnées de lieu correspondantes.

7. Dispositif de mesure selon la revendication 1, **caractérisé en ce que**, pour le transport du substrat (4) en forme de panneau, il est prévu un dispositif de transport (5 à 9) sur lequel repose une arête latérale du substrat (4).

8. Dispositif de mesure selon la revendication 1, **caractérisé en ce que**, l'émetteur de lumière (12) est disposé dans un boîtier, dans lequel se trouve également un récepteur de lumière, pour que la réflexion du revêtement soit mesurable.

## FIG.1

## FIG.2

# FIG.3

# FIG.4

# FIG.5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3806382 A1
- US 6359686 B1

- EP 2004002333 A